# EUROPEAN PATENT SPECIFICATION

(11) **EP 4 494 182 B1**
(45) Date of publication and mention of the grant of the patent: **18.02.2026**
(21) Application number: 23713579.3
(22) Date of filing: 15.03.2023
(51) Int. Cl.: H01L 23/00

(54) **SINTER READY MULTILAYER WIRE/RIBBON BOND PADS AND METHOD FOR DIE TOP ATTACHMENT**
SINTERBEREITE MEHRSCHICHTIGE DRAHT-/BANDBONDPADS UND VERFAHREN ZUR CHIPOBERBEFESTIGUNG
PLOTS DE CONNEXION DE FILS/RUBANS MULTICOUCHES PRÊTS À FRITTER ET PROCÉDÉ DE FIXATION SUR DESSUS DE PUCE

(30) Priority: 15.03.2022 US 202263319891 P
(43) Date of publication of application: 22.01.2025
(60) Divisional application: 25156858.0
(73) Proprietor: Alpha Assembly Solutions Inc., Waterbury, CT 06702 (US)
(72) Inventor: SIEBENHUHNER, Matthew, Waterbury, CT 06702 (US); MO, Bin, Waterbury, CT 06702 (US); BOUREGHDA, Monnir, Waterbury, CT 06702 (US); FENECH, Maurizio, Waterbury, CT 06702 (US); BANKIEWICZ, Bogdan, Waterbury, CT 06702 (US); KHASELEV, Oscar, Waterbury, CT 06702 (US); SINGH, Bawa, Waterbury, CT 06702 (US)
(74) Representative: Novagraaf Group
(86) International application number: PCT/EP2023/025116
(87) International publication number: WO 2023/174581

(56) References cited:
- EP-B1- 3 026 703
- US-A1- 2017 033 073
- US-A1- 2018 166 415
- US-A1- 2020 290 160
- US-A1- 2021 078 080

## Description

The present invention relates to a sinterable silver film, a bond pad comprising the sinterable silver film, a method of manufacturing a bond pad and, a method for connecting a die to a copper wire and/or copper ribbon.

In conventional power modules, bond wires connecting, for example, a semiconductor / die and a substrate are typically formed of aluminium. As the power density requirements of power modules increases, manufacturers have started to use copper bond wires, which offer extra current carrying capacity and better heat conduction and dissipation. The conditions for welding a copper wire to a semiconductor / die tend to be more rigorous than for aluminium wires, which may cause damage to the underlying semiconductor / die. As a result, it is common to attach a thin film of copper, known as a "bond pad" to the top of a die. The bond pad provides uniform current distribution (e.g. in short circuit conditions) and better heat dissipation, and may avoid substantial damage to the underlying die when the die is welded to the copper wire.

The technology described in US10079219B2 involves a flexible contacting film (bond pad) sintered onto the regions of varying thickness of the sintering layer applied to the top side of the die or other substrate. Sinter material is applied in a pasty form, dried in an undulating pattern and sintered to a metal molded body. Further, wire or ribbons are ultrasonically welded to the flexible contacting film. There are significant challenges in the implementation of such a technology in mass production of semiconducting devices. For example, application of a sintered layer is done typically through stencil, screen or other types of printing. Printing small areas such as the top side of the die is difficult and is a poorly controlled process. Misprints or paste bleed out are frequent occurrences which can damage the device by shorting electrical terminals or by producing other defects. Moreover, the top side of the die is usually patterned with the help of dielectric barrier layers which stand out above the surface by 10-15 microns and further complicate the printing process. Creating reproducible paste deposits of varying thickness print on dies as small as 5 x 5 mm is unattainable in a high volume manufacturing (HVM) environment.

Instead of applying sintering paste to the top side of a die, it is possible to provide sintering paste to the base of a bond pad. This may be achieved either by printing sintering paste onto the base, or by applying paste to a copper foil and then cutting the copper foil into individual bond pads. The former is susceptible to the issues discussed above, and the latter may require the use of accurate cutting using, for example, a laser. This may result in a more complicated manufacturing method. Furthermore, the final bond pad may not be robust enough to be handled using conventional tape-and-reel technology, and may instead require the use of a dicing tape.

EP3026703A1 relates to a method for producing a substrate adapter, a substrate adapter and a method for contacting a semiconductor. US2018166415A1 relates to a method for die and clip attachment. US2020290160A1 relates to a sheet for sintering bonding and a sheet for sintering bonding with base material. US2017033073A1 relates to a low-pressure sintering powder. US2021078080A1 relates to a film-shaped firing material and a film-shaped firing material with a support sheet.

The present invention aims to solve at least some of the problems associated with the prior art or to provide a commercially acceptable alternative.

In a first aspect, the present invention provides a sinterable silver film according to claim 1.

Each aspect or embodiment as defined herein may be combined with any other aspect(s) or embodiment(s) unless clearly indicated to the contrary. In particular, any features indicated as being preferred or advantageous may be combined with any other feature indicated as being preferred or advantageous.

A method according to a reference example will now be described. The method may result in a bond pad with a high-quality bond line between the copper foil and the sinterable film. Advantageously, in comparison to conventional methods, the method of the reference example may be less complex. In particular, the method may not require the use of accurate printing and/or cutting techniques.

In comparison to conventional bond pads, a bond pad manufactured using the method may be more robust. As a result, it can be more easily handled without being damaged, thereby requiring fewer considerations during its use in a method of manufacturing an electronic device, such as a power module or printed circuit board.

The bond pad is for connecting a die to a copper ribbon or copper wire. This may be in the context of a power module or printed circuit board. In other words, the bond pad may be for connecting a die to a copper ribbon or copper wire in a power module and/or for connecting a die to a copper ribbon or copper wire in a printed circuit board. The copper ribbon or copper wire may be considered to be an interconnect, i.e. the copper ribbon or copper wire may be a copper ribbon interconnect or copper wire interconnect.

The bond pad may be suitable to be stored in waffle packs or tapes typically used in pick-and-place equipment. Accordingly, the bond pads may be particularly suited for use in high-speed manufacturing lines.

The method comprises providing a sheet of copper foil having a first major surface opposite a second major surface. By "first major surface" and "second major surface" is meant the two sides of the sheet, i.e. the two surfaces with the greatest area.

The method comprises providing a sinterable film of metal particles. By "sinterable" it is meant that the film is capable of undergoing sintering on the application of heat and/or pressure to form a metallic joint between two surfaces. The sinterable film is free-standing. In other words, the sinterable film may substantially retain its integrity when handled. This may distinguish the film from a dried layer of sintering paste applied to a surface, which would otherwise likely break up if handled or transferred from one surface to another. The sinterable film comprises metal particles. The sinterable film may comprise species other than metal particles. The metal particles may be in the form of one or more of spheres, rods and plates. The metal particles may comprise nanoparticles, i.e. have a mean longest dimension of from 1 to 1000 microns, as measured using TEM or laser diffraction. Examples of suitable sinterable films and their methods of manufacture are described in US10535628B2 and US10710336B2. A commercial example of a suitable sinterable film is MacDermid Alpha Sinter Ready Film.

The method comprises forming a laminated sheet by laminating the first major surface with the sinterable film. The laminated sheet therefore comprises the sinterable film and the sheet of copper foil. The sinterable film is laminated on the first major surface. The sinterable film is not also laminated on the second major surface. In fact, the second major surface typically remains uncoated. This may enable the copper foil to be welded to a copper ribbon or copper wire.

The method comprises punching (out) a bond pad from the laminated sheet. Punching techniques and punching equipment are known in the art. A commercial example of a suitable punching press is the Lingshen punching press. Suitable punching presses are also offered by Kaka Industry, Samhoor and others. Punching is sometimes referred to in the art as "stamping".

The copper foil preferably comprises copper or copper alloy, and/or is a multilayered structure. This may result in a particularly effective bond bad.

The copper foil preferably has a thickness of from 10 to 200 µm, more preferably from 50 to 150 µm. Thicker foils may increase the cost of the method and/or unduly increase the thickness of the bond pad, thereby unduly increasing the size of a printed circuit board or power module formed using the bond pad. Thinner foils may result in damage to an underlying die when a copper ribbon or wire is welded to the copper foil. However, the copper foil may preferably have a thickness of less than 50 µm, e.g. from 10 µm to less than 50 µm.

The copper foil preferably has a hardness HV of from 50 to 100 using a 300 g load. Higher hardness values may make it more difficult to weld a copper ribbon or copper wire to the copper foil. Lower hardness values may result in in damage to an underlying die when a copper ribbon or wire is welded to the copper foil.

The copper foil preferably has a coefficient of thermal expansion (CTE) of from 10 to 20 K⁻¹. This may avoid an unfavourable level of thermal stress during sintering and/or welding.

The copper foil may be unperforated. Alternatively, the copper foil is preferably perforated. In use, this may provide stress relief to a device containing the bond pad. In this regard, the copper foil may comprise multiple perforations and/or may be porous and/or mesh-like.

The metal particles preferably comprise one or more of silver particles, copper particles, silver-coated copper particles, copper-coated silver particles, gold particles, palladium particles, aluminum particles, silver palladium alloy particles and gold palladium alloy particles, more preferably silver particles. The metal particles preferably have a longest dimension of from 1 to 1000 nm.

The sinterable film of the reference example method preferably comprises: silver particles having a longest dimension of from 1 to 1000 nm, and a polymer binder. Silver particles may exhibit particularly favourable sintering properties and result in a sintered joint with particularly favourable electrical and thermal conductivity. Smaller particles may be difficult to handle. Larger particles may require unfavourably high sintering temperatures and/or pressures that may decrease the energy efficiency of the method and/or cause damage to a die or substrate. When the silver particles are in the form of spheres, the longest dimension is the diameter of the spheres. The longest dimension may be measured using TEM or laser diffraction. The use of a binder may ensure that the film is capable of being "free-standing".

The sinterable film preferably comprises from 0.1 to 2 wt.% of the polymer binder, preferably from 0.5 to 1 wt.% of the polymer binder based on the total weight of the sinterable silver film.

The polymer binder preferably comprises an amide polymer, more preferably poly(N-vinyl acetamide). Such species are particularly effective binders.

The silver particles (or metal particles) preferably have a longest dimension of from 5 to 500 nm, preferably from 10 to 100 nm, more preferably from 30 to 60 nm. This may result in particularly favourable sintering and handling properties. The longest dimension may be measured using TEM or laser diffraction.

Preferably, silver particles (or metal particles) in the sinterable film form a particulate having: a D90 of 1000 nm or less, preferably 500 nm or less, more preferably 100 nm or less, even more preferably 60 nm or less; and/or a D10 of 1 nm or more, more preferably 5 nm or more, even more preferably 10 nm or more, still even more preferably 30 nm or more. Such particle size distributions may result in particularly favorable sintering and handling properties.

The sinterable film preferably comprises from 90 to 99 wt.% silver particles (or metal particles), more preferably from 92 to 98 wt.% silver particles (or metal particles), even more preferably from 94 to 96 wt.% silver particles (or metal particles) based on the total weight of the sinterable film. Higher levels of particles may result in the sinterable film exhibiting unfavourable mechanical / handling properties. Lower levels of particles may result in high levels of species other than silver (e.g. binder or a remnant thereof) being present in the final sintered joint, thereby unfavourably affecting its mechanical and/or electrical and/or thermal properties.

The sinterable film comprises a halogenated alcohol activator having a melting point of from 80 to 150 °C. Such a sinterable film may be particularly effective at joining the bond pad to a die in an electronic device manufacturing method. Surprisingly, the inventors have found that the sinterable silver film may be "hot tacked" to a die during a method of connecting a die to a copper wire or copper ribbon. This may avoid the need to employ a taking agent, remnants of which may reside in the final sintered joint and reduce its integrity.

The term "hot tacking" as used herein may encompass a process in which a sinterable film is attached to a surface by the application of heat and typically also pressure. Such attachment occurs without substantial sintering of the metal particles in the sintering film. Accordingly, the sinterable film may remain in a desired position during an attachment method while retaining its ability to form a joint between the bond pad and the surface of a die. Without being bound by theory, it is considered that hot tacking is achieved by means of limited metallic diffusion between the sinterable film and the surface to which it is "tacked", such as the top of a die.

The presence of the halogenated alcohol activator may remove oxides from the surface to which the sinterable film is to be tacked, e.g. the top surface of a die. This may ensure that tacking can occur to an extent sufficient to attach the sinterable film to the surface but at a temperature low enough to avoid substantial sintering of the metal particles contained in the sinterable film. Without being bound by theory, it is considered that this may be due to the increased level of metallic diffusion that is possible as a result of the removal of surface oxides.

Furthermore, the presence of the halogenated alcohol activator may make it easier to laminate the first major surface with the sinterable film, and may mean that such lamination may occur under gentler conditions. Furthermore, the use of a metal plating layer (such as a silver plating layer) on the first major surface, which would otherwise facilitate metallic diffusion during the lamination, may not be required.

The sinterable film preferably comprises from 0.05 to 1 wt.% of the halogenated alcohol activator, more preferably from 0.1 to 0.2 wt.% of the halogenated alcohol activator based on the total weight of the sinterable film.

The halogenated alcohol activator preferably has a melting point of from 85 to 140 °C, more preferably from 90 to 130 °C, even more preferably from 100 to 120 °C. This may render the activator "active" at typical lamination and/or hot-tacking temperatures. At lower temperatures, the activator will be solid, meaning that there will be no changes in the mechanical properties of the sinterable film that would affect its ability to be handled as a result of melting of the activator.

The halogenated alcohol activator has a molecular weight of: at least 150, preferably at least 200; and/or 500 or less, preferably 400 or less, more preferably 300 or less; and/or from 150 to 500, preferably from 200 to 300.

The halogenated alcohol preferably comprises a brominated alcohol, more preferably a dibrominated alcohol. The halogenated alcohol preferably comprises from 3 to 5 carbon atoms. The halogenated alcohol preferably comprises a monohydroxy alcohol. The halogenated alcohol may be linear or branched. Such alcohols may be particularly effective at removing surface oxides.

The sinterable film preferably further comprises: partially hydrogenated gum rosin, preferably in an amount of from 0.1 to 0.3 wt.% based on the total weight of the sinterable silver film; and/or micronized wax, preferably in an amount of from 0.2 to 0.4 wt.% based on the total weight of the sinterable silver film.

Laminating the first major surface with the sinterable film preferably comprises: contacting the sinterable film with the first surface; and applying heat and pressure to the sheet of copper foil and sinterable film.

The first surface preferably comprises a metal plating layer and contacting the sinterable film with the first surface comprises contacting the metal plating layer with the sinterable silver film. This may enable lamination to occur at lower temperatures and/or pressures. Without being bound by theory, this may be because metallic diffusion between the metal particles and the metal plating layer may be more pronounced than between the metal particles and the copper foil.

The metal plating layer preferably comprises silver, nickel-gold alloy and/or ENIG, more preferably silver. When the sinterable film comprises silver particles, the metal plating layer preferably comprises silver. Diffusion of silver into a silver plating layer may be more pronounced than into the copper foil.

The metal plating layer preferably has a thickness of from 1 to 5 µm. Smaller thicknesses may not adequately promote metallic diffusion. Larger thicknesses may unduly increase the size of a device formed using the bond pad.

Applying heat and pressure to the sheet of copper foil and sinterable film preferably comprises: applying a pressure of at least 0.5 MPa, preferably at least 0.8 MPa, more preferably from 0.5 to 2 MPa, even more preferably from 0.8 to 1.2 MPa, still even more preferably about 1 MPa; and/or heating the sheet of copper foil and/or sinterable film to a temperature of from 100 to 200 °C, preferably from 120 to 170 °C, more preferably from 140 to 160 °C, even more preferably about 150 °C, preferably for from 1 to 60 seconds, more preferably from 2 to 40 seconds, even more preferably from 5 to 15 seconds, still even more preferably for about 10 seconds. This may result in an adequate level of adhesion between the sheet of copper foil and sinterable film without causing substantial sintering of the sinterable film.

Preferably, the method further comprises applying tack agent to the sinterable film on the laminated sheet, and the punching is carried out such that tack agent is present on the sinterable film on the bond pad. This may enable "cold tacking" of the bond pad to a die, i.e. tacking at temperatures of less than 100 °C, or less than 90 °C. This may be beneficial where the die is attached to a substrate that may become damaged and or oxidised at higher temperatures. The tacking agent may be applied in any shape but is typically applied in multiple, discrete areas. In other words, multiple, discrete deposits of tack may be applied. Following punching, each bond pad may comprise, for example, from 1 to 4 discrete deposits of tack. Tack may be applied using hot melt jetting using commercially available equipment such as Nordson Unity PJ30XT. While tack agent is preferably applied before punching because it is easier to apply it to a continuous strip, the tack agent may be applied after punching.

The tack agent preferably comprises: a diphenyl compound, preferably having a melting point of from 50 to 90 °C; and/or a triphenyl compound, preferably having a melting point of from 50 to 90 °C; and/or a fatty alcohol, preferably having a melting point of from 30 to 60 °C. In a preferred embodiment, the tack agent comprises polyvinylether. Such species may exhibit high levels of "tack" at typical cold tacking temperatures but exhibit limited levels of tack at lower temperatures, thereby rendering them easier to handle. Such species may have substantially evaporated at typical sintering temperatures, meaning that such species are substantially absent from the final sintered joint.

Another reference example provides a bond pad manufactured according to the method described herein.

The advantages and preferable features of the first reference example apply equally to this reference example.

In a first aspect, the present invention provides a sinterable silver film comprising:
silver particles having a longest dimension of from 1 to 1000 nm,
a polymer binder, and
a halogenated alcohol activator having a melting point of from 80 to 150 °C.

The advantages and preferable features of the above reference examples apply equally to this aspect. The sinterable film may be particularly suitable for attaching a bond pad to a die.

The silver particles preferably have a longest dimension of from 5 to 500 nm, preferably from 10 to 100 nm, more preferably from 30 to 60 nm.

Silver particles in the sinterable silver film preferably form a particulate having: a D90 of 1000 nm or less, preferably 500 nm or less, more preferably 100 nm or less, even more preferably 60 nm or less; and/or a D10 of 1 nm or more, preferably 5 nm or more, more preferably 10 nm or more, even more preferably 30 nm or more.

The sinterable silver film preferably comprises from 90 to 99 wt.% silver metal particles, more preferably from 92 to 98 wt.% silver metal particles, even more preferably from 94 to 96 wt.% silver metal particles based on the total weight of the sinterable film.

The sinterable silver film preferably comprises from 0.1 to 2 wt.% of the polymer binder, more preferably from 0.5 to 1 wt.% of the polymer binder based on the total weight of the sinterable silver film.

The polymer binder preferably comprises an amide polymer, more preferably poly(N-vinyl acetamide).

The sinterable silver film preferably comprises from 0.05 to 1 wt.% of the halogenated alcohol activator, more preferably from 0.1 to 0.2 wt.% of the halogenated alcohol activator based on the total weight of the sinterable silver film.

The halogenated alcohol activator preferably has a melting point of from 85 to 140 °C, more preferably from 90 to 130 °C, even more preferably from 100 to 120 °C.

The halogenated alcohol activator preferably has a molecular weight of: at least 150, preferably at least 200; and/or 500 or less, preferably 400 or less, more preferably 300 or less; and/or from 150 to 500, preferably from 200 to 300.

The halogenated alcohol preferably comprises a brominated alcohol, more preferably a dibrominated alcohol. The halogenated alcohol preferably comprises from 3 to 5 carbon atoms. The halogenated alcohol preferably comprises a monohydroxy alcohol.

The sinterable silver film preferably comprises: partially hydrogenated gum rosin, preferably in an amount of from 0.1 to 0.3 wt.% based on the total weight of the sinterable silver film; and/or micronized wax, preferably in an amount of from 0.2 to 0.4 wt.% based on the total weight of the sinterable silver film.

In a further aspect, the present invention provides a bond pad for connecting a die to a copper wire or copper ribbon, the bond pad comprising:
a copper foil,
the sinterable silver film described herein laminated on the copper foil, and
optionally a metal plating layer sandwiched between the copper foil and the sinterable silver film.

The advantages and preferable features of the first aspect apply equally to this aspect.

The copper foil preferably comprises copper or copper alloy, and/or is a multilayered structure.

The copper foil preferably has a thickness of from 10 to 200 µm, more preferably from 50 to 150 µm.

The copper foil preferably has a hardness Hv of from 50 to 100.

The copper foil preferably has a coefficient of thermal expansion (CTE) of from 10 to 20 K⁻¹.

The copper foil is preferably perforated.

The metal plating layer preferably comprises silver, nickel-gold alloy and/or ENIG (electroless nickel immersion gold).

The metal plating layer preferably has a thickness of from 1 to 5 µm.

The bond pad preferably further comprises a tack agent on the outer surface of the sinterable silver film.

The tack agent preferably comprises: a diphenyl compound, preferably having a melting point of from 50 to 90 °C; and/or a triphenyl compound, preferably having a melting point of from 50 to 90 °C; and/or a fatty alcohol, preferably having a melting point of from 30 to 60 °C.

The tack agent preferably comprises polyvinylether.

In a further aspect, the present invention provides a method for connecting a die to a copper wire and/or copper ribbon, the method comprising:
providing a die,
providing the bond pad described herein,
contacting the sinterable silver film of the bond pad with the die,
heating the sinterable film to connect the bond pad to the die, and
welding a copper wire and/or copper ribbon to the copper foil of the bond pad.

The advantages and preferable features of the first aspect apply equally to this aspect.

Contacting the sinterable film of the bond pad with the die may be carried out, for example, using standard die pick-and-place equipment such as Datacon 2200EVO or Infotech Die Bonder.

The welding preferably comprises ultrasonic welding and/or laser welding. Such welding may be capable of forming a particularly strong connection between the die / bond pad and the copper wire and/or copper ribbon.

Welding a copper wire and/or copper ribbon to the copper foil of the bond pad typically comprises welding the copper wire and/or copper ribbon to the second major surface of the copper foil.

Heating the sinterable film to connect the bonding pad to the die typically comprises sintering of the sinterable film, thereby forming a metallic joint between the bond pad and the die.

The heating is preferably carried out at a temperature of from 200 to 300 °C, more preferably from 220 to 280 °C, even more preferably from 240 to 260 °C. Higher temperatures may cause damage to the die or a substrate to which it is attached. Lower temperatures may result in inadequate sintering of the sinterable film, resulting in a weak joint.

The heating is preferably carried out under a pressure of from 2 to 20 MPa, more preferably from 5 to 15 MPa, even more preferably from 8 to 12 MPa, still even more preferably about 10 MPa. Higher pressures may cause damage to the die or a substrate to which it is attached. Lower pressures may result in inadequate sintering of the sinterable film, resulting in a weak joint.

The heating is preferably carried out for from 10 to 180 seconds, more preferably from 30 to 120 seconds, even more preferably from 50 to 100 seconds, still even more preferably from 60 to 90 seconds. Longer times may be unnecessary and not lead to any greater level of adhesions. Shorter times may result in inadequate sintering of the sinterable film, resulting in a weak joint.

The die preferably comprises a metallized surface, more preferably comprising silver, gold and/or palladium, and contacting the sinterable film of the bond pad with the die comprises contacting the sinterable film of the bond pad with the metallized surface of the die. This may result in a stronger joint.

Contacting the sinterable film of the bond pad with the die preferably comprises: preheating the die to a temperature of from 130 to 180 °C, and contacting the preheated die with the sinterable film with a force of from 50 to 150 N, more preferably from 70 to 130 N, even more preferably from 80 to 100 N, still even more preferably about 90 N and/or with a placement time of from 100 to 2000 ms, more preferably from 200 to 1000 ms. The application of such heat and pressure may promote limited metallic diffusion between the sinterable film and the die, thereby fixing the bond pad to the die (so-called "hot-tacking"). Accordingly, the bond pad may be held in a desired position during the method.

Preferably, the die comprises a tack agent on a surface thereof; contacting the sinterable film of the bond pad with the die comprises contacting the sinterable film of the bond pad with the tack agent; and contacting the sinterable film of the bond pad with the die is carried out using a pick-and-place tool preheated to 50 to 90 °C. The tack agent may hold the bond pad in a desired position during the method (so-called "cold-tacking"). This may be achieved at a lower temperature (e.g. room temperature) than "hot-tacking", which may be beneficial where the die and/or substrate to which it is attached may become damaged at higher temperatures. Typically, the tack agent will exhibit "tackiness" at the temperature of the pick-and-place machine. The placement time may be short, for example as short as 50 to 100 milliseconds, which may enable high production rate.

In a further aspect, the present application provides a method of manufacturing an electronic device comprising connecting a die to a copper wire and/or copper ribbon according to the method described herein.

The advantages and preferable features of the first aspect apply equally to this aspect.

A reference example provides an electronic device manufactured according to the method described herein.

The advantages and preferable features of the first aspect apply equally to this reference example.

A reference example provides an electronic device comprising the bond pad described herein.

The advantages and preferable features of the first aspect apply equally to this reference example.

The electronic device preferably comprises a power device or a power module.

The electronic device preferably further comprises a substrate connected to the die via a sintered silver film.

In a further aspect, the present invention provides a method of manufacturing the bond pad described herein, the method comprising:
providing a copper foil;
providing the sinterable silver film described herein;
contacting the copper foil with the sinterable silver film;
applying heat and pressure to the copper foil and sinterable silver film to laminate the sinterable silver film on the copper foil to provide a laminated copper foil; and
punching bond pads from the laminated copper foil.

The advantages and preferable features of the first aspect apply equally to this aspect.

The sinterable silver film preferably comprises a metal plating layer and contacting the copper foil with the sinterable silver film comprises contacting the metal plating layer with the sinterable silver film.

Applying heat and pressure to the copper foil and sinterable silver film preferably comprises: applying a pressure of at least 0.5 MPa, preferably at least 0.8 MPa, more preferably from 0.5 to 2 MPa, even more preferably from 0.8 to 1.2 MPa, still even more preferably about 1 MPa; and/or heating the copper foil and/or sinterable silver film to a temperature of from 100 to 200 °C, preferably from 120 to 170 °C, more preferably from 140 to 160 °C, even more preferably about 150 °C, preferably for from 1-60 second, more preferably from 2 to 40 second, even more preferably from 5 to 15 second, still even more preferably for about 10 seconds.

In a further aspect, the present invention provides a method of assembly according to claim 9.

The advantages and preferable features of the first aspect apply equally to this aspect.

Providing the bond pad preferably comprises providing the bond pad on a tape-and-reel assembly and contacting the bond pad with the die is preferably carried out using a pick-and-place machine. Sintering may be carried out, for example, in a sintering press. The sintering conditions may comprise, for example, a pressure of from 1 to 15 MPa (e.g. 10 MPa), a temperature of from 200 to 300 °C (e.g. 250 °C) and a time of from 1 to180 seconds (e.g. from 60 to 90 seconds).

The invention will now be further described with reference to the following drawings in which:
Figure 1 is a schematic of a bond pad according to the present invention.
Figure 2 is a schematic of an electronic device manufactured according to the present invention.
Figure 3 is a photograph of an electronic device manufactured according to the present invention.

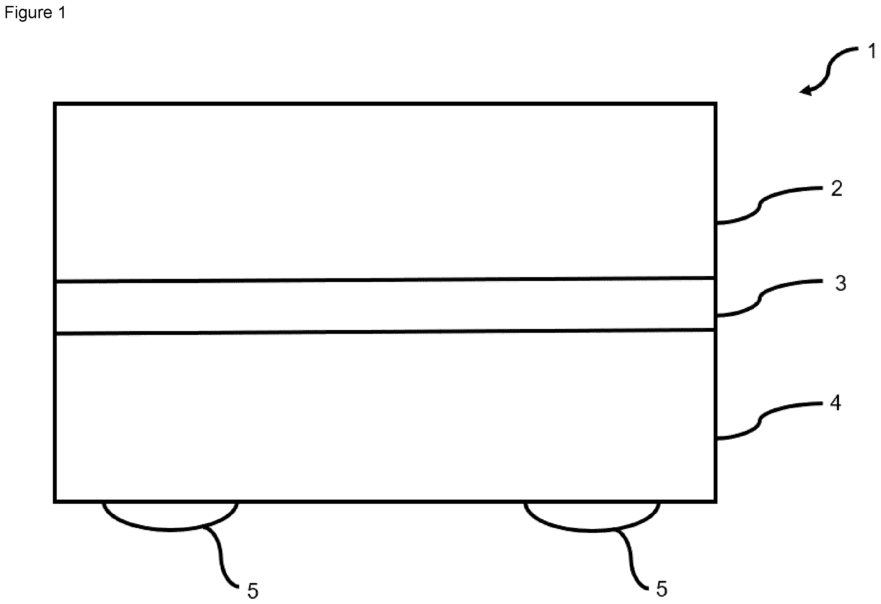

Referring to Figure 1, there is shown a bond pad (generally at 1) according to the present invention. The bond pad comprises a copper foil 2 having a plating layer 3 on its surface. A sinterable silver film 4 is laminated on the copper foil 2 via the plating later 3. Tack agent 5 is situated on the outer surface of the sinterable silver film 4.

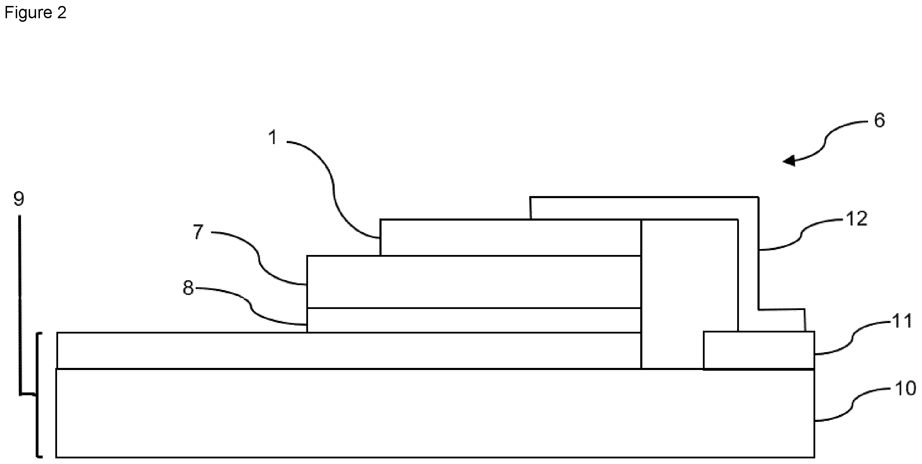

Referring to Figure 2, there is shown an electronic device (generally at 6) manufactured according to the present invention. A bond pad 1 according to the present invention is attached to a die 7 via the sinterable silver film of the bond pad (not shown). The die 7 is attached via a sinterable silver film 8 to a substrate 9. The substrate comprises a ceramic core 10 and a copper surface layer 11. A copper wire 12 is welded to the top of the bond pad 1 and the copper surface layer 11.

The invention will now be further described with reference to the following example.

### Example

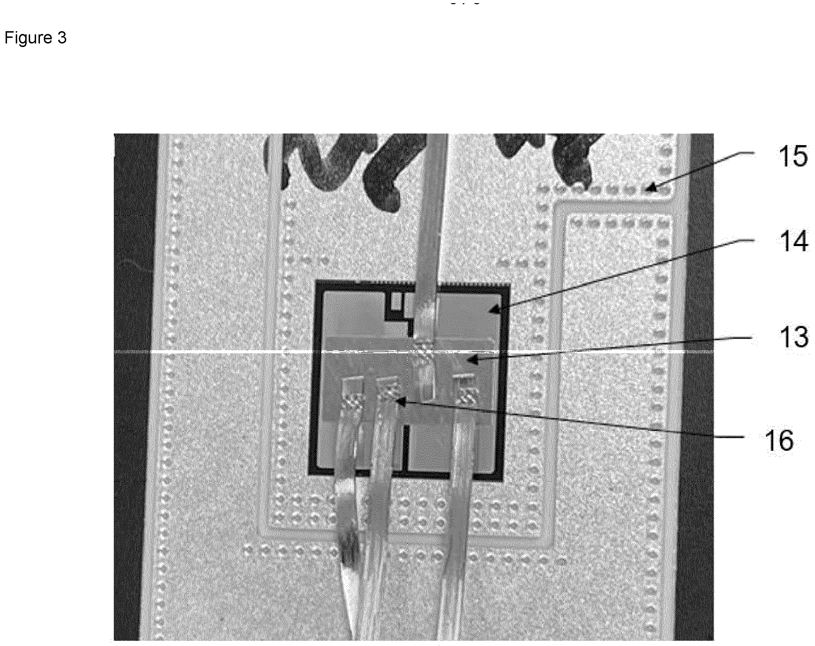

An electronic device was prepared according to the following method. A substrate was provided having a die thereon, the substrate and die separated by a sinterable film. A 50 µm thick bond pad was prepared comprising a metal plated hard copper foil having sinterable silver film laminated thereon. The bond pad was placed via the sinterable film onto the top of the die. The resulting blank was transferred to an oven where the sinterable films were sintered to form metallic joints between the bond pad and the top of the die, and between the die and the substrate. Copper ribbons were then ultrasonically welded to the top of the bod pad. The results are shown in Figure 3 with the bond pad labelled 13, the die labelled 14, the substrate labelled 15 and the copper ribbons labelled 16.

An identical electronic device was prepared but in which the copper foil comprised soft copper.

The connection between the bond pads and the copper ribbons of both devices were subjected to shear testing using the industry accepted shear test as described in Technical Bulletin DVS 2811. The results are as follows:

| Shear strength in kg | |
|---|---|
| Soft-Cu | Hard-Cu |
| 4.167 | 5.518 |
| 5.263 | 4.945 |
| 5.470 | 4.323 |
| 4.230 | 4.969 |

In both cases, shear strength was excellent, far exceeding recommended values. The failure mode was between copper ribbon and the pad as recommended by the standard.

The foregoing detailed description has been provided by way of explanation and illustration, and is not intended to limit the scope of the appended claims.

## Claims

1. A sinterable silver film (4) comprising:
silver particles having a longest dimension of from 1 to 1000 nm, and
a polymer binder,
**characterized in that** the sinterable silver film (4) further comprises a halogenated alcohol activator having a melting point of from 80 to 150 °C.

2. The sinterable silver film (4) of claim 1, wherein:
the silver particles have a longest dimension of from 5 to 500 nm, preferably from 10 to 100 nm, more preferably from 30 to 60 nm; and/or
the sinterable silver film (4) comprises from 90 to 99 wt.% silver metal particles, preferably from 92 to 98 wt.% silver metal particles, more preferably from 94 to 96 wt.% silver metal particles based on the total weight of the sinterable film (4); and/or
the sinterable silver film (4) comprises from 0.1 to 2 wt.% of the polymer binder, preferably from 0.5 to 1 wt.% of the polymer binder based on the total weight of the sinterable silver film (4); and/or
the polymer binder comprises an amide polymer, preferably poly(N-vinyl acetamide); and/or
the sinterable silver film (4) comprises from 0.05 to 1 wt.% of the halogenated alcohol activator, preferably from 0.1 to 0.2 wt.% of the halogenated alcohol activator based on the total weight of the sinterable silver film (4); and/or
the halogenated alcohol activator has a melting point of from 85 to 140 °C, preferably from 90 to 130 °C, more preferably from 100 to 120 °C.

3. The sinterable silver film (4) of claim 1 or claim 2, wherein the halogenated alcohol activator:
has a molecular weight of at least 150, preferably at least 200; and/or
has a molecular weight of 500 or less, preferably 400 or less, more preferably 300 or less; and/or
has a molecular weight of from 150 to 500, preferably from 200 to 300; and/or
comprises a brominated alcohol, preferably a dibrominated alcohol; and/or
comprises from 3 to 5 carbon atoms; and/or
comprises a monohydroxy alcohol.

4. A bond pad (1) for connecting a die (7) to a copper wire (12) or copper ribbon, the bond pad (1) comprising:
a copper foil (2),
the sinterable silver film (4) of any of claims 1 to 3 laminated on the copper foil (2), and
optionally a metal plating layer (3) sandwiched between the copper foil (2) and the sinterable silver film (4).

5. The bond pad (1) of claim 4, wherein:
the copper foil (2) comprises copper or copper alloy, and/or is a multilayered structure; and/or
the copper foil (2) has a thickness of from 10 to 200 µm, preferably from 50 to 150 µm; and/or
the copper foil (2) has a hardness Hv of from 50 to 100 using a 300 g load; and/or
the copper foil (2) has a coefficient of thermal expansion (CTE) of from 10 to 20 ppm; and/or
the copper foil (2) is perforated; and/or
the metal plating layer (3) comprises silver, nickel-gold alloy and/or electroless nickel immersion gold; and/or
the metal plating layer (3) has a thickness of from 1 to 5 µm.

6. A method of manufacturing the bond pad (1) of claim 4 or claim 5, the method comprising:
providing a copper foil (2);
providing the sinterable silver film (4) of any of claims 1 to 3;
contacting the copper foil (2) with the sinterable silver film (4);
applying heat and pressure to the copper foil (2) and sinterable silver film (4) to laminate the sinterable silver film (4) on the copper foil (2) to provide a laminated copper foil (2); and
punching bond pads (1) from the laminated copper foil (2).

7. A method for connecting a die (7) to a copper wire (12) and/or copper ribbon, the method comprising:
providing a die (7),
providing the bond pad (1) of claim 4 or claim 5,
contacting the sinterable silver film (4) of the bond pad (1) with the die (7),
heating the sinterable film (4) to connect the bond pad (1) to the die (7), and
welding a copper wire (12) and/or copper ribbon to the copper foil (2) of the bond pad (1).

8. A method of manufacturing an electronic device (3) comprising connecting a die (7) to a copper wire (12) and/or copper ribbon according to the method of claim 6.

9. A method of assembly comprising connecting a die (7) to a copper wire (12) and/or copper ribbon using the method of claim 7, wherein the step of providing a die (7) comprises providing a substrate (9) having a die (7) thereon, the substrate (9) and die (7) separated by a sinterable film (8), wherein the method comprises connecting the copper ribbon or copper wire (12) to the substrate (9).

10. The method of claim 9, wherein providing the bond pad (1) comprises providing the bond pad (1) on a tape-and-reel assembly and contacting the bond pad (1) with the die (7) is carried out using a pick-and-place machine.

## Patentansprüche

1. Sinterbarer Silberfilm (4), umfassend:
Silberpartikel, die eine längste Abmessung von 1 bis 1000 nm aufweisen,
und
ein Polymerbindemittel,
**dadurch gekennzeichnet, dass** der sinterbare Silberfilm (4) ferner einen halogenierten Alkoholaktivator umfasst, der einen Schmelzpunkt von 80 bis 150 °C aufweist.

2. Sinterbarer Silberfilm (4) nach Anspruch 1, wobei:
die Silberpartikel eine längste Abmessung von 5 bis 500 nm aufweisen, vorzugsweise von 10 bis 100 nm, mehr bevorzugt von 30 bis 60 nm; und/oder
der sinterbare Silberfilm (4) zu 90 bis 99 Gew.-% Silbermetallpartikel umfasst, vorzugsweise zu 92 bis 98 Gew.-% Silbermetallpartikel, mehr bevorzugt zu 94 bis 96 Gew.-% Silbermetallpartikel, basierend auf dem Gesamtgewicht des sinterbaren Films (4); und/oder
der sinterbare Silberfilm (4) zu 0,1 bis 2 Gew.-% das Polymerbindemittel umfasst, vorzugsweise zu 0,5 bis 1 Gew.-% das Polymerbindemittel, basierend auf dem Gesamtgewicht des sinterbaren Silberfilms (4); und/oder
das Polymerbindemittel ein Amidpolymer umfasst, vorzugsweise Poly(N-vinylacetamid); und/oder
der sinterbare Silberfilm (4) zu 0,05 bis 1 Gew.-% den halogenierten Alkoholaktivator umfasst, vorzugsweise zu 0,1 bis 0,2 Gew.-% den halogenierten Alkoholaktivator, basierend auf dem Gesamtgewicht des sinterbaren Silberfilms (4); und/oder
der halogenierte Alkoholaktivator einen Schmelzpunkt von 85 bis 140 °C aufweist, vorzugsweise von 90 bis 130 °C, mehr bevorzugt von 100 bis 120 °C.

3. Sinterbarer Silberfilm (4) nach Anspruch 1 oder 2, wobei der halogenierte Alkoholaktivator:
ein Molekulargewicht von mindestens 150 aufweist, vorzugsweise mindestens 200; und/oder
ein Molekulargewicht von 500 oder weniger aufweist, vorzugsweise 400 oder weniger, mehr bevorzugt 300 oder weniger; und/oder
ein Molekulargewicht von 150 bis 500 aufweist, vorzugsweise von 200 bis 300; und/oder
einen bromierten Alkohol umfasst, vorzugsweise einen dibromierten Alkohol; und/oder
von 3 bis 5 Kohlenstoffatome umfasst; und/oder
einen Monohydroxyalkohol umfasst.

4. Bondpad (1) zum Verbinden eines Chips (7) mit einem Kupferdraht (12) oder Kupferband, das Bondpad (1) umfassend:
eine Kupferfolie (2),
den sinterbaren Silberfilm (4) nach einem der Ansprüche 1 bis 3, der auf die Kupferfolie (2) laminiert ist, und
wahlweise eine Metallplattierungsschicht (3), die sandwichartig zwischen der Kupferfolie (2) und dem sinterbaren Silberfilm (4) angeordnet ist.

5. Bondpad (1) nach Anspruch 4, wobei:
die Kupferfolie (2) Kupfer oder Kupferlegierung umfasst und/oder eine mehrschichtige Struktur ist; und/oder
die Kupferfolie (2) eine Dicke von 10 bis 200 µm aufweist, vorzugsweise von 50 bis 150 µm; und/oder
die Kupferfolie (2) eine Härte Hv von 50 bis 100 unter Verwendung einer 300 g-Last aufweist; und/oder
die Kupferfolie (2) einen Koeffizienten der thermischen Ausdehnung (CTE) von 10 bis 20 ppm aufweist; und/oder
die Kupferfolie (2) perforiert ist; und/oder
die Metallplattierungsschicht (3) Silber, Nickel-Gold-Legierung und/oder stromloses Nickel-Immersionsgold umfasst; und/oder
die Metallplattierungsschicht (3) eine Dicke von 1 bis 5 µm aufweist.

6. Verfahren zum Herstellen des Bondpads (1) nach Anspruch 4 oder 5, das Verfahren umfassend:
Bereitstellen einer Kupferfolie (2);
Bereitstellen des sinterbaren Silberfilms (4) nach einem der Ansprüche 1 bis 3;
Inberührungbringen der Kupferfolie (2) mit dem sinterbaren Silberfilm (4);
Anwenden von Wärme und Druck auf die Kupferfolie (2) und den sinterbaren Silberfilm (4), um den sinterbaren Silberfilm (4) auf die Kupferfolie (2) zu laminieren, um eine laminierte Kupferfolie (2) bereitzustellen; und
Stanzen von Bondpads (1) aus der laminierten Kupferfolie (2).

7. Verfahren zum Verbinden eines Chips (7) mit einem Kupferdraht (12) und/oder Kupferband, das Verfahren umfassend:
Bereitstellen eines Chips (7),
Bereitstellen des Bondpads (1) nach Anspruch 4 oder 5,
Inberührungbringen des sinterbaren Silberfilms (4) des Bondpads (1) mit dem Chip (7),
Erwärmen des sinterbaren Films (4), um das Bondpad (1) mit dem Chip (7) zu verbinden, und
Schweißen eines Kupferdrahts (12) und/oder Kupferbands an die Kupferfolie (2) des Bondpads (1).

8. Verfahren zum Herstellen einer elektronischen Vorrichtung (3), umfassend das Verbinden eines Chips (7) mit einem Kupferdraht (12) und/oder Kupferband gemäß dem Verfahren nach Anspruch 6.

9. Verfahren für eine Montage, umfassend das Verbinden eines Chips (7) mit einem Kupferdraht (12) und/oder Kupferband unter Verwendung des Verfahrens nach Anspruch 7, wobei der Schritt des Bereitstellens eines Chips (7) das Bereitstellen eines Substrats (9) umfasst, das einen Chip (7) darauf aufweist, wobei das Substrat (9) und der Chip (7) durch einen sinterbaren Film (8) getrennt sind, wobei das Verfahren das Verbinden des Kupferbands oder Kupferdrahts (12) mit dem Substrat (9) umfasst.

10. Verfahren nach Anspruch 9, wobei das Bereitstellen des Bondpads (1) das Bereitstellen des Bondpads (1) auf einer Tape-and-Reel-Anordnung umfasst und das Inberührungbringen des Bondpads (1) mit dem Chip (7) unter Verwendung einer Pick-and-Place-Maschine durchgeführt wird.

## Revendications

1. Film d'argent frittable (4) comprenant :
des particules d'argent ayant une dimension la plus longue de 1 à 1000 nm, et
un liant polymère,
**caractérisé en ce que** le film d'argent frittable (4) comprend en outre un activateur d'alcool halogéné dont le point de fusion est compris entre 80 et 150 °C.

2. Film d'argent frittable (4) selon la revendication 1, dans lequel :
les particules d'argent ont une dimension la plus longue de 5 à 500 nm, de préférence de 10 à 100 nm, plus préférablement de 30 à 60 nm ; et/ou
le film d'argent frittable (4) comprend de 90 à 99 % en poids de particules d'argent métal, de préférence de 92 à 98 % en poids de particules d'argent métal, plus préférablement de 94 à 96 % en poids de particules d'argent métal par rapport au poids total du film frittable (4) ; et/ou
le film d'argent frittable (4) comprend de 0,1 à 2 % en poids du liant polymère, de préférence de 0,5 à 1 % en poids du liant polymère par rapport au poids total du film d'argent frittable (4) ; et/ou
le liant polymère comprend un polymère amide, de préférence un poly(N-acétamide vinylique) ; et/ou
le film d'argent frittable (4) comprend de 0,05 à 1 % en poids de l'activateur d'alcool halogéné, de préférence de 0,1 à 0,2 % en poids de l'activateur d'alcool halogéné par rapport au poids total du film d'argent frittable (4) ; et/ou
l'activateur d'alcool halogéné a un point de fusion compris entre 85 et 140 °C, de préférence entre 90 et 130 °C, plus préférablement entre 100 et 120 °C.

3. Film d'argent frittable (4) selon la revendication 1 ou la revendication 2, dans lequel l'activateur d'alcool halogéné :
a un poids moléculaire d'au moins 150, de préférence d'au moins 200 ; et/ou
a un poids moléculaire inférieur ou égal à 500, de préférence inférieur ou égal à 400, de préférence inférieur ou égal à 300 ; et/ou
a un poids moléculaire compris entre 150 et 500, de préférence entre 200 et 300 ; et/ou
comprend un alcool bromé, de préférence un alcool dibromé ; et/ou
comprend de 3 à 5 atomes de carbone ; et/ou
comprend un monohydroxyalcool.

4. Plaque de liaison (1) destiné à relier une matrice (7) à un fil de cuivre (12) ou à un ruban de cuivre, la plaque de liaison (1) comprenant :
une feuille de cuivre (2),
le film d'argent frittable (4) selon l'une quelconque des revendications 1 à 3 laminé sur la feuille de cuivre (2), et
éventuellement, une couche de métallisation (3) prise en sandwich entre la feuille de cuivre (2) et le film d'argent frittable (4).

5. Plaque de liaison (1) selon la revendication 4, dans lequel :
la feuille de cuivre (2) comprend du cuivre ou un alliage de cuivre, et/ou est une structure multicouche ; et/ou
la feuille de cuivre (2) a une épaisseur de 10 à 200 µm, de préférence de 50 à 150 µm ; et/ou
la feuille de cuivre (2) a une dureté Hv de 50 à 100 avec une charge de 300 g ; et/ou
la feuille de cuivre (2) a un coefficient de dilatation thermique (CTE) de 10 à 20 ppm ; et/ou
la feuille de cuivre (2) est perforée ; et/ou
la couche de placage métallique (3) comprend de l'argent, un alliage nickel-or et/ou de l'or par immersion dans du nickel chimique ; et/ou
la couche de placage métallique (3) a une épaisseur comprise entre 1 et 5 µm.

6. Procédé de fabrication de la plaque de liaison (1) selon la revendication 4 ou la revendication 5, le procédé comprenant :
la fourniture d'une feuille de cuivre (2) ;
la fourniture du film d'argent frittable (4) selon l'une quelconque des revendications 1 à 3 ;
la mise en contact de la feuille de cuivre (2) avec le film d'argent frittable (4) ;
l'application de la chaleur et de la pression à la feuille de cuivre (2) et au film d'argent frittable (4) pour laminer le film d'argent frittable (4) sur la feuille de cuivre (2) afin d'obtenir une feuille de cuivre laminée (2) ; et
la découpe des plaques de liaison (1) dans la feuille de cuivre laminée (2).

7. Procédé destiné à relier une matrice (7) à un fil de cuivre (12) et/ou à un ruban de cuivre, le procédé comprenant :
la fourniture d'une matrice (7),
la fourniture de la plaque de liaison (1) selon la revendication 4 ou la revendication 5,
la mise en contact du film d'argent frittable (4) de la plaque de liaison (1) avec la matrice (7),
le chauffage du film frittable (4) pour relier la plaque de liaison (1) à la matrice (7), et
le soudage d'un fil de cuivre (12) et/ou d'un ruban de cuivre à la feuille de cuivre (2) de la plaque de liaison (1).

8. Procédé de fabrication d'un dispositif électronique (3) comprenant la liaison d'une matrice (7) à un fil de cuivre (12) et/ou à un ruban de cuivre selon le procédé de la revendication 6.

9. Procédé d'assemblage comprenant la liaison d'une matrice (7) à un fil de cuivre (12) et/ou à un ruban de cuivre à l'aide du procédé selon la revendication 7, dans lequel l'étape consistant à fournir une matrice (7) comprend la fourniture d'un substrat (9) ayant une matrice (7) sur celui-ci, le substrat (9) et la matrice (7) étant séparés par un film frittable (8), dans lequel le procédé comprend la liaison du ruban de cuivre ou du fil de cuivre (12) au substrat (9).

10. Procédé selon la revendication 9, dans lequel la fourniture de la plaque de liaison (1) comprend la fourniture de la plaque de liaison (1) sur un assemblage de bandes et de bobines et la mise en contact de la plaque de liaison (1) avec la matrice (7) est réalisée à l'aide d'une machine de prise et de mise en place.
